# EUROPEAN PATENT APPLICATION

(11) **EP 4 510 399 A1**
(43) Date of publication of application: **19.02.2025**
(21) Application number: 23788082.8
(22) Date of filing: 09.03.2023
(51) Int. Cl.: H01S 5/343, H01L 21/205, H01L 33/10, H01L 33/32, H01S 5/183

(54) **NITRIDE SEMICONDUCTOR LIGHT EMITTING ELEMENT AND METHOD FOR PRODUCING NITRIDE SEMICONDUCTOR LIGHT EMITTING ELEMENT**

(30) Priority: 14.04.2022 JP 2022066965
(71) Applicant: Meijo University, Nagoya-shi, Aichi 468-8502 (JP); Stanley Electric Co., Ltd., Meguro-ku Tokyo 153-8636 (JP)
(72) Inventor: TAKEUCHI, Tetsuya, Nagoya-shi, Aichi 468-8502 (JP); KOBAYASHI, Kenta, Nagoya-shi, Aichi 468-8502 (JP); SHIBATA, Kana, Nagoya-shi, Aichi 468-8502 (JP); IWAYA, Motoaki, Nagoya-shi, Aichi 468-8502 (JP); KAMIYAMA, Satoshi, Nagoya-shi, Aichi 468-8502 (JP); KURAMOTO, Masaru, Tokyo 153-8636 (JP)
(74) Representative: Müller-Boré & Partner Patentanwälte PartG mbB
(86) International application number: PCT/JP2023/009019
(87) International publication number: WO 2023/199660

(57) **Abstract**

Provided are a nitride semiconductor light emitting element of good quality and a method for producing a nitride semiconductor light emitting element of good quality.

A nitride semiconductor light emitting element (1) includes an n-AlInN layer (12) containing Al and In in its composition, a GaN cap layer (13) stacked on a surface of the n-AlInN layer (12) and containing Ga in its composition, and an n-AlGaN composition gradient layer (14) stacked on a surface of the GaN cap layer (13) and containing Al and Ga in its composition. A molar fraction of AlN at an interface of the n-AlGaN composition gradient layer (14) stacked on the surface of the GaN cap layer (13) is 0.36 or more and 0.44 or less.

## Description

### TECHNICAL FIELD

The present invention relates to a nitride semiconductor light emitting element and a method for producing the nitride semiconductor light emitting element.

### BACKGROUND ART

When a semiconductor multilayer film is produced by stacking nitride semiconductor thin films having different band gaps and refractive indexes, there has been a problem that defects such as threading dislocation are present at high density particularly in a multilayer film reflecting mirror formed of a nitride semiconductor thin film containing In. Specifically, there is a concern that a defect may occur in a hetero junction in which a nitride semiconductor thin film free of In such as GaN is formed on a nitride semiconductor thin film containing In such as AlInN.

Patent Literature 1 discloses that a structure in which the percentage of decrease in the In composition at the interface between an upper part of an AlInN layer and a lower part of a GaN layer is made larger than the percentage of decrease in the Al composition, that is, a structure in which a layer containing a substantially small amount of In is present at the interface between the AlInN layer and the GaN layer, suppresses the occurrence of defects such as threading dislocation. Specifically, it is disclosed that the occurrence of defects is suppressed by forming a cap layer not containing In of more than 0 nm and 1 nm or less immediately after forming an AlInN layer, and thereafter performing a temperature increasing step of increasing the substrate temperature to remove clusters of In present on the surface of the AlInN layer. Here, the cap layer includes not only a state of uniformly covering the surface of the AlInN layer but also a state of being formed in an island shape on the surface of the AlInN layer. Patent Literature 2 discloses that providing an AlGaN layer having an Al composition (AlN molar fraction) of less than 20% (0.2) on a cap layer by several nm increases an effective step difference in refractive index and increases reflectance thereof.

### CITATIONS LIST

### PATENT LITERATURE

Patent Literature 1: JP 2018-98347 A
Patent Literature 2: JP 2018-98340 A
Non Patent Literature 1: Schulz, et al., "Composition dependent band gap and band edge bowing in AlInN: A combined theoretical and experimental study" Appl. Phys. Express 6, 121001 (2013)
Non Patent Literature 2: Coughlan, et al., "Band gap bowing and optical polarization switching in Al1-xGaxN alloys" Phys. Stat. Sol. B 252,879 (2015)
Non Patent Literature 3: Bernardini, et al., "Spontaneous polarization and piezoelectric constants of III-V nitrides" Phys. Rev. B 56, R10024 (1997)

### SUMMARY OF INVENTION

### TECHNICAL PROBLEMS

Under such circumstances, for the purpose of forming an element structure, a nitride semiconductor thin film multilayer film reflecting mirror structure having conductivity, which is advantageous from the viewpoint of current injection, has been studied, and as a result, the following new problems have been found. Specifically, this is a case where an n-AlGaInN composition gradient layer to which Si is added is provided on an n-AlInN layer to form a multilayer film reflecting mirror structure having conductivity. First, an n-AlGaInN composition gradient layer of 5 nm, that is, a layer whose composition is gradually changed from n-AlInN to n-GaN, was formed on an n-AlInN layer at the same growth temperature as that of the n-AlInN layer so as to contain necessary In. Thereafter, a GaN cap layer of 0.3 nm was formed according to Patent Literature 1, and then a temperature increasing step of increasing the substrate temperature was performed.

Although the multilayer film reflecting mirror prepared in such a step showed good conductivity, it has been found that many pits (holes) are generated on the surface as compared with a non-conductive multilayer film reflecting mirror in the case of not using the n-AlGaInN composition gradient. This is considered to be because the n-AlGaInN composition gradient layer is formed with a thickness of 5 nm at the same temperature (that is, a low temperature) as that of the n-AlInN layer, which causes a GaN layer having a thickness of 1 nm or more to be substantially present on the surface side, and the effect of reducing pits and threading dislocation is diminished. On the other hand, good conductivity is not obtained even when Si as an n-type impurity is added while an n-AlGaN layer having an AlN molar (mol) fraction of 20% (0.2) or less is provided according to Patent Literature 2. As described above, it has become clear that only the techniques disclosed in Patent Literatures 1 and 2 cannot provide a multilayer film reflecting mirror having favorable conductivity in which dislocation generation is suppressed.

The present invention has been made in view of the above conventional circumstances, and an object of the present invention is to provide a nitride semiconductor light emitting element having a high output and a long life, and a method for producing the nitride semiconductor light emitting element by obtaining a multilayer film reflecting mirror having a low pit density on the surface, that is, having few defects and having good conductivity.

### SOLUTIONS TO PROBLEMS

A nitride semiconductor light emitting element according to a first aspect of the present invention includes:
a first layer containing Al and In in its composition;
a cap layer stacked on a surface of the first layer and containing Ga in its composition; and
a second layer stacked on a surface of the cap layer and containing Al and Ga in its composition,
wherein a molar fraction of AlN at an interface of the second layer stacked on the surface of the cap layer is 0.36 or more and 0.44 or less.

With this configuration, an energy barrier generated between the first layer and the second layer can be reduced so that exchange of electrons between the first layer and the second layer can be improved.

A method for producing a nitride semiconductor light emitting element according to a second aspect of the present invention is a method for producing a nitride semiconductor light emitting element using metal organic vapor phase epitaxy, the method including:
a first layer stacking step of crystal-growing a first layer containing Al and In in its composition;
a cap layer stacking step of crystal-growing a cap layer containing Ga in its composition on a surface of the first layer after the first layer stacking step is performed;
a second layer stacking step of crystal-growing a second layer containing Al and Ga in its composition on a surface of the cap layer after the cap layer stacking step is performed; and
a third layer stacking step of crystal-growing a third layer containing Ga in its composition on a surface of the second layer after the second layer stacking step is performed,
wherein a temperature at which the second layer is crystal-grown in the second layer stacking step is equal to or higher than a temperature at which the third layer is crystal-grown in the third layer stacking step.

With this configuration, the migration of Al can be activated in the second layer stacking step, and thus the surface of the second layer can be easily flattened, which leads to an improvement in quality of the third layer which is subsequently crystal-grown.

### BRIEF DESCRIPTION OF DRAWINGS

Fig. 1 is a schematic view illustrating an example of a structure of a nitride semiconductor light emitting element produced by a method for producing a nitride semiconductor light emitting element.
Fig. 2 is a graph showing a change in an energy barrier when the composition is changed from GaN to AlN and from AlN to InN.
Fig. 3 is a graph showing a relationship between a polarization charge density at an interface between an n-AlInN layer and an n-AlGaN composition gradient layer and a starting AlN molar fraction in the n-AlGaN composition gradient layer.
Fig. 4 is a graph showing a relationship between an energy barrier generated at an interface between an n-AlInN layer and an n-AlGaN composition gradient layer and a starting AlN molar fraction.
Fig. 5(A) is a schematic view illustrating structures of samples of Examples 1 to 4 and Comparative Examples 1 and 2, and Fig. 5(B) is a table showing starting AlN molar fractions, growth temperatures, and differential resistance values in Examples 1 to 4 and Comparative Examples 1 and 2.
Fig. 6 is a graph showing a relationship between a voltage and a current in the samples of Examples 1 to 4 and Comparative Examples 1 and 2.
Fig. 7 is a graph obtained by plotting a relationship of the starting AlN molar fraction with respect to the differential resistance value in the samples of Examples 1 to 4 and Comparative Example 1.
Fig. 8 is a graph obtained by plotting differential resistance values at a plurality of places in each of the samples of Examples 1 to 4 and Comparative Example 1.
Fig. 9 is a graph showing a relationship between a maximum reflectance and a thickness of an n-AlGaN composition gradient layer.
Fig. 10 is a graph showing a relationship between the energy barrier generated at an interface between an n-AlInN layer and an n-AlGaN composition gradient layer and the thickness of the n-AlGaN composition gradient layer.
Fig. 11 is an AFM image obtained by measuring a surface of each of Example 5 and Comparative Examples 3 and 4 over a range of 10 µm × 10 µm.

### DESCRIPTION OF EMBODIMENT

A preferred embodiment of the present invention will be described.

In the first aspect of the present invention, a third layer stacked on a surface of the second layer, having a smaller molar fraction of AlN than that of the first layer, and containing Ga in the composition may be further provided, and the composition of the second layer may be inclined such that the molar fraction of AlN in the second layer gradually decreases toward an interface with the third layer. With this configuration, an energy barrier generated at the interface between the second layer and the third layer can be reduced, so that conductivity between the second layer and the third layer can be improved, and consequently, exchange of electrons from the first layer to the third layer can be improved (that is, conductivity can be improved).

In the first aspect of the present invention, the cap layer may have a thickness in a stacking direction of larger than 0 and 1 nm or less. With this configuration, the surface of the first layer can be favorably protected.

In the first aspect of the present invention, the second layer may have a thickness in the stacking direction of 4 nm or more and 15 nm or less. With this configuration, both a low differential resistance value and high reflection can be achieved.

### <Examples 1 to 4, Comparative Examples 1 to 2>

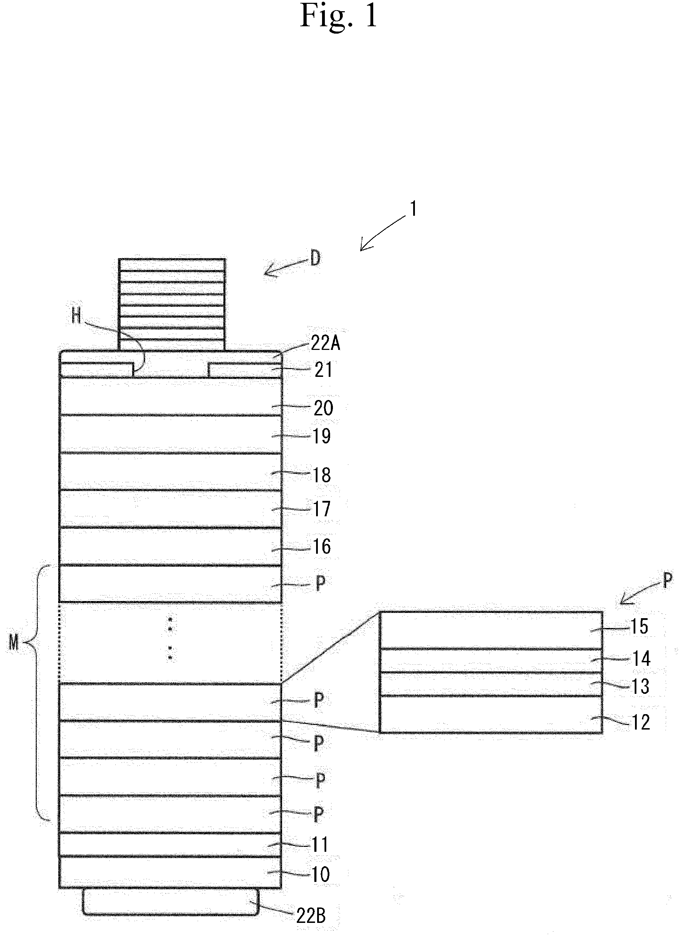

Next, an example in which a nitride semiconductor light emitting element of the present invention is embodied will be described with reference to the drawings. Specifically, it is an example of a method for forming an n-AlInN/GaN multilayer film reflecting mirror structure including an n-AlGaN composition gradient layer 14 on the surface side of an n-AlInN layer 12 and a method for producing a surface-emitting laser (hereinafter, also referred to as nitride semiconductor light emitting element 1) using this structure. The n-AlInN/GaN multilayer film reflecting mirror structure can be used not only in a surface-emitting laser but also in various optical device structures such as light emitting diodes and solar cells. Fig. 1 illustrates a schematic sectional view of an example of a structure of a surface-emitting laser (nitride semiconductor light emitting element 1) using this structure.

As illustrated in Fig. 1, the nitride semiconductor light emitting element 1 includes an n-GaN substrate 10, an n-GaN buffer layer 11, an n-AlInN/GaN multilayer film reflecting mirror M, a second n-GaN layer 16, a GaInN quantum well active layer 17, a p-AlGaN layer 18, a p-GaN layer 19, a p-GaN contact layer 20, a p-side electrode 22A, and an n-side electrode 22B. The n-AlInN/GaN multilayer film reflecting mirror M is formed by repeating four layers of the n-AlInN layer 12 as a first layer, the GaN cap layer 13 as a cap layer, the n-AlGaN composition gradient layer 14 as a second layer, and the first n-GaN layer 15 as a third layer, 40 times. The n-GaN substrate 10 is a GaN single crystal substrate having n-type characteristics. The nitride semiconductor light emitting element 1 can be produced by performing epitaxial growth using metal organic vapor phase epitaxy (MOVPE) on a surface of the n-GaN substrate 10, that is, a Ga surface (an upper surface in Fig. 1).

In producing the nitride semiconductor light emitting element 1, trimethylaluminum (TMA), trimethylgallium (TMGa), triethylgallium (TEGa), and trimethylindium (TMI) are used as group III materials (MO raw materials). Ammonia (NH₃) is used as a raw material gas of a group V material. Silane (SiH₄) is used as a raw material gas of a donor impurity. Cyclopentadienyl magnesium (CP₂Mg) is used as an MO raw material of an acceptor impurity.

First, the n-GaN buffer layer 11 as a buffer layer is crystal grown on a surface of the n-GaN substrate 10. The thickness of the n-GaN buffer layer 11 in the stacking direction is 500 nm. Here, the stacking direction is an up-down direction in Fig. 1. Hereinafter, a thickness in the stacking direction is also simply referred to as a thickness. Specifically, the n-GaN substrate 10 is disposed in a reaction furnace of an MOVPE apparatus (hereinafter, also simply referred to as in the reaction furnace). Then, the temperature in the reaction furnace is adjusted such that the temperature (growth temperature) of the n-GaN substrate 10 becomes 1050°C, and H₂ (hydrogen) is supplied into the reaction furnace as a carrier gas. The supply amount of SiH₄ into the reaction furnace is adjusted such that the concentration of Si (silicon) in the n-GaN buffer layer 11 becomes 5 × 10¹⁸ cm⁻³.

### [First layer stacking step]

Next, a first layer stacking step is performed. Specifically, the n-AlInN layer 12 containing Al and In in composition is epitaxially grown on a surface of the n-GaN buffer layer 11. In detail, the temperature in the reaction furnace is adjusted such that the temperature (growth temperature) of the n-GaN substrate 10 becomes 840°C, and N₂ (nitrogen) is supplied into the reaction furnace as a carrier gas. In addition, TMA, TMI, SiH₄, and NH₃ are supplied into the reaction furnace to crystal-grow the n-AlInN layer 12 having a thickness of 38 nm in the stacking direction. The molar fraction of AlN in the n-AlInN layer 12 is about 810 (0.81), and the molar fraction of InN is about 19% (0.19).

Basically, it is preferable that a lattice constant of an n-AlGaN composition gradient layer 14 to be described later matches a lattice constant of the n-GaN substrate 10 serving as a substrate, but the lattice constant of the n-AlGaN composition gradient layer 14 in this example is set to be smaller than the lattice constant of the n-GaN substrate 10, and in order to compensate for the lattice constant, the molar fraction of InN in the n-AlInN layer 12 is slightly increased (by less than 1% (0.01)) to about 19% (0.19). As a result, the cumulative lattice distortion in the entire multilayer film reflecting mirror structure is canceled. The molar fraction of AlN and the molar fraction of InN in the n-AlInN layer 12 are not limited to the numerical values disclosed in this example, and they only need to be values that can cancel the cumulative lattice distortion in the entire multilayer film reflecting mirror structure. The supply amount of SiH₄ into the reaction furnace is adjusted such that the concentration of Si in the n-AlInN layer 12 becomes 1.5 × 10¹⁹ cm⁻³. In addition to N₂, the carrier gas may be an inert gas such as Ar or Ne (neon), or a mixed gas thereof.

### [Cap layer stacking step]

Next, after the first layer stacking step is performed, a cap layer stacking step is performed. Specifically, the supply of TMA, TMI, and SiH₄ is stopped with the temperature (growth temperature) of the n-GaN substrate 10 and the supply of the carrier gas (N₂) and NH₃ into the reaction furnace being maintained, and TEGa is supplied into the reaction furnace to crystal-grow the GaN cap layer 13 on a surface of the n-AlInN layer 12. The GaN cap layer 13 contains Ga in composition. The thickness of the GaN cap layer 13 in the stacking direction is 0.6 nm. When the thickness of the GaN cap layer 13 is less than 1 nm, there is no significant influence even though SiH₄ is not added, but SiH₄ may be supplied. When SiH₄ is supplied, the concentration of Si is adjusted to about 5 × 10¹⁸ cm⁻³.

As described below, it is preferable to adjust the thickness of the GaN cap layer 13 according to the substrate temperature at the time of crystal growth in the step subsequent to the cap layer stacking step. For example, when the substrate temperature at the time of crystal growth in the step subsequent to the cap layer stacking step is set to a temperature higher than the substrate temperature in the cap layer stacking step, the thickness of the GaN cap layer 13 is set to be larger. This can reduce damages to the surface of the n-AlInN layer 12 due to a high substrate temperature in the subsequent step and makes the surface of the n-AlInN layer 12 flatter. Specifically, when the substrate temperature in the subsequent step is about 1050°C, the thickness of GaN cap layer 13 is preferably from 0.3 nm to 0.6 nm. When the substrate temperature in the subsequent step is 1100°C or higher, the thickness of GaN cap layer 13 is preferably from 0.6 nm to 1 nm. That is, regardless of the substrate temperature, the thickness of the GaN cap layer 13 in the stacking direction only needs to be larger than 0 and 1 nm or less.

### [Temperature increasing step]

Next, a temperature increasing step is performed. Specifically, after the supply of TEGa is stopped, the temperature (growth temperature) of the n-GaN substrate 10 is increased to 1100°C, which is the growth temperature of the n-AlGaN composition gradient layer 14, while maintaining the supply of NH₃ into the reaction furnace and gradually switching the carrier gas to be supplied into the reaction furnace from N₂ to H₂. At this time, since the supply of TMA, TMGa, TEGa, TMI, and SiH₄ into the reaction furnace is stopped, the crystal growth is interrupted. In this manner, after the thin GaN cap layer 13 free of In is formed, on the surface of the GaN cap layer 13, the temperature increasing step of increasing the temperature of the n-GaN substrate 10 is performed. This makes it possible to remove clusters of In present on the surface of the n-AlInN layer 12 and suppress the occurrence of defects as disclosed in Patent Literature 1. However, since the n-AlGaN composition gradient layer 14 containing Al having high binding energy in the composition is crystal grown in the subsequent step, it is necessary to activate the migration of Al on the surface of the substrate. Thus, by setting the growth temperature in the second layer stacking step to be equal to or higher than the growth temperature in the first n-GaN layer 15 stacked on the surface of the n-AlGaN composition gradient layer 14, a flatter surface of the n-AlGaN composition gradient layer 14 can be obtained.

### [Second layer stacking step]

Next, a second layer stacking step is performed. Specifically, after the temperature of the n-GaN substrate 10 reaches 1100°C, supply of TMGa, TMAl, and SiH₄ into the reaction furnace is started, and the n-AlGaN composition gradient layer 14 containing Al and Ga and free of In is crystal-grown. The thickness of the n-AlGaN composition gradient layer 14 in the stacking direction is 5 nm. The n-AlGaN composition gradient layer 14 is stacked on a surface of the GaN cap layer 13. The n-AlGaN composition gradient layer 14 is crystal-grown in the following manner.

First, crystal growth is started with a predetermined supply amount of TMA and TMGa. The molar fraction of AlN at the start of crystal growth of the n-AlGaN composition gradient layer 14 (hereinafter, also simply referred to as starting AlN molar fraction) can be adjusted by changing the ratio of the supply amounts of TMA and TMGa. Immediately after the start of crystal growth of the n-AlGaN composition gradient layer 14, the supply amount of TMA into the reaction furnace is gradually reduced, and the supply amount of TMGa is gradually increased. Finally, the supply of TMA into the reaction furnace is completely stopped, and TMGa is increased to a supply amount at which the growth rate is almost the same as the growth rate at the start of the growth of the n-AlGaN composition gradient layer 14. This allows crystal growth of the n-AlGaN composition gradient layer 14 in which the composition is changed with a gradient in the stacking direction from n-AlGaN when the crystal growth starts to n-GaN when the crystal growth ends. That is, the composition of the n-AlGaN composition gradient layer 14 is inclined such that the molar fraction of AlN in the n-AlGaN composition gradient layer 14 gradually decreases toward the interface with the first n-GaN layer 15 described later. The thickness of the n-AlGaN composition gradient layer 14 is 5 nm. The n-AlGaN composition gradient layer 14 has a preferable thickness, which will be described later. To obtain n-type characteristics, the supply amount of SiH₄ into the reaction furnace is adjusted such that the concentration of Si in the n-AlGaN composition gradient layer 14 becomes 6 × 10¹⁹ cm⁻³.

After the supply of TMGa and SiH₄ is stopped and the growth of the n-AlGaN composition gradient layer 14 is finished, the temperature of the n-GaN substrate 10 is lowered to 1050°C, which is an appropriate temperature for the next crystal growth of the first n-GaN layer 15. That is, the temperature (1100°C) at which the n-AlGaN composition gradient layer 14 is crystal-grown in the second layer stacking step is higher than the temperature (1050°C) at which the first n-GaN layer 15 is crystal-grown in a third layer stacking step to be performed next.

### [Third layer stacking step]

Next, after the second layer stacking step is performed, the third layer stacking step is performed. Specifically, after the temperature of the n-GaN substrate 10 reaches 1050°C, supply of TMGa into the reaction furnace is started, and the first n-GaN layer 15 having a thickness of 43 nm in the stacking direction and containing Ga in the composition is crystal-grown. The molar fraction of AlN in the first n-GaN layer 15 is 0 (that is, smaller than that in the n-AlInN layer 12). The supply amount of SiH₄ into the reaction furnace is adjusted such that the concentration of Si in the first n-GaN layer 15 becomes 5 × 10¹⁸ cm⁻³. The n-AlInN layer 12, the GaN cap layer 13, the n-AlGaN composition gradient layer 14, and the first n-GaN layer 15 correspond to one pair P of the multilayer film reflecting mirror structure.

After the first n-GaN layer 15 is crystal-grown, the supply of TMGa into the reaction furnace is stopped and the crystal growth is interrupted in order to crystal-grow the n-AlInN layer 12 on a surface of the first n-GaN layer 15 again (that is, the pair P is repeatedly crystal-grown). Then, while the crystal growth is interrupted, the temperature of the n-GaN substrate 10 is lowered from 1050°C to 840°C. At this time, the carrier gas is gradually switched from H₂ to N₂. In this manner, crystal growth of one pair P (the n-AlInN layer 12, the GaN cap layer 13, the n-AlGaN composition gradient layer 14, and the first n-GaN layer 15) in the multilayer film reflecting mirror structure is repeated 40 times, thereby crystal-growing the n-AlInN/GaN multilayer film reflecting mirror M in which 40 pairs P are stacked.

### [Verification of starting AlN molar fraction of AlGaN composition gradient layer]

Here, the nitride semiconductor light emitting element 1 uses the n-AlInN layer 12 and the n-AlGaN composition gradient layer 14. Thus, the connection of the band structure at the hetero interface formed by the upper part of the n-AlInN layer 12 and the lower part of the n-AlGaN composition gradient layer 14 (that is, the n-AlGaN composition gradient layer 14 at the start of growth) with the GaN cap layer 13 interposed therebetween has a large influence on the conductivity of the multilayer film structure.

That is, since electrons move in a layer having n-type conductivity properties such as the n-AlInN layer 12 and the n-AlGaN composition gradient layer 14, it is extremely important to select the starting AlN molar fraction such that an unnecessary barrier does not occur in the energy level at the hetero interface at the lower end of the conduction band. Instead of the n-AlGaN composition gradient layer 14, when an AlGaInN composition gradient layer in which the composition is adapted from the composition of the n-AlInN layer 12 to the composition of the first n-GaN layer 15 by continuously changing the molar fractions of AlN, GaN, and InN along with crystal growth is used, the band gap continuously changes from the n-AlInN layer 12 to the first n-GaN layer 15, and thus the above-described problem does not occur.

To obtain the starting AlN molar fraction at which no unnecessary barrier is generated in the energy level at the hetero interface at the lower end of the conduction band, it is important to consider both the band offset of the conduction band based on the difference in the band gap between the AlInN layer and the AlGaN layer and the polarization charge offset based on the difference in polarization charge. Specifically, it is considered that there is a molar fraction of AlN in which both the band offset of the conduction band based on the difference in band gap between the AlInN layer and the AlGaN layer and the polarization charge offset based on the difference in polarization charge are zero.

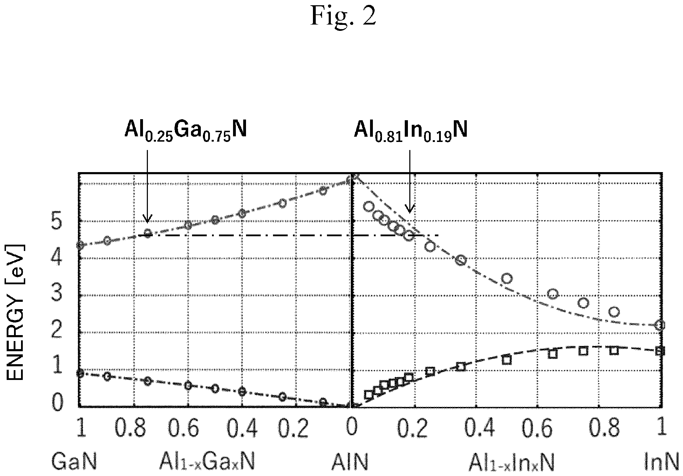

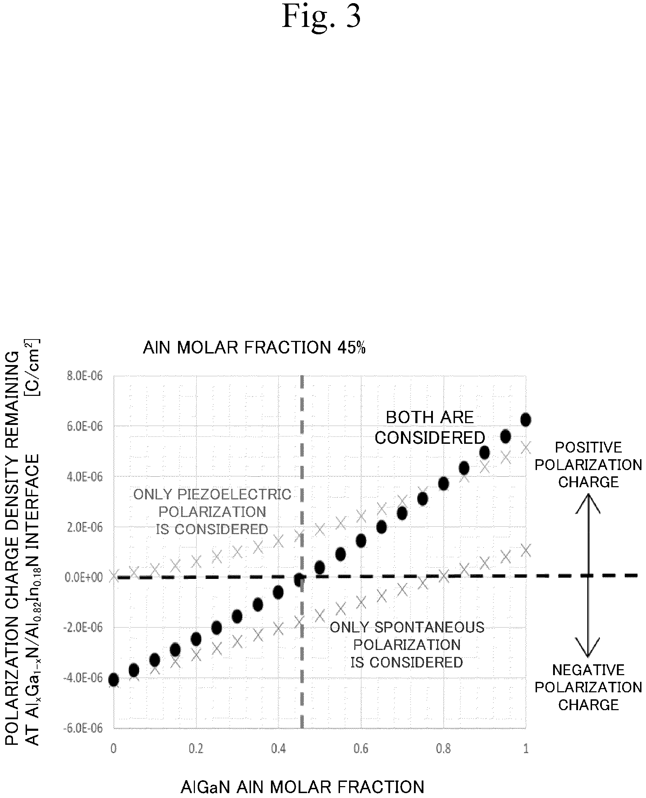

Here, the molar fraction of AlN in AlGaN having the same lower end of the conduction band as that of the n-AlInN layer 12 (AlN molar fraction is 0.81) used in the n-AlInN/GaN multilayer film reflecting mirror M was calculated by using the physical property values disclosed in Non Patent Literatures 1 and 2, and it was found that the value was 0.25 (see Fig. 2). On the other hand, using the physical property values disclosed in Non Patent Literature 3, the molar fraction of AlN in AlGaN whose offset is 0 in accordance with the polarization charge in the upper portion of the n-AlInN layer 12 was calculated, and it was found that the value was 0.45 (see Fig. 3).

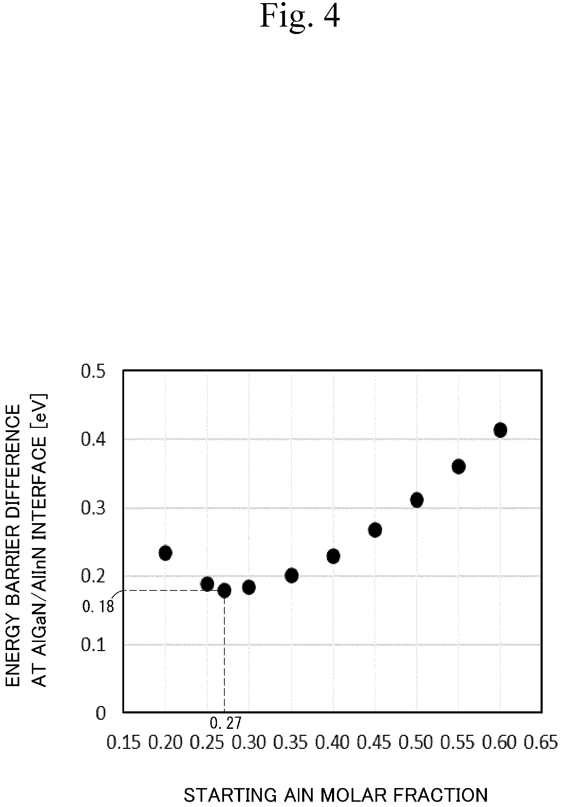

A potential barrier to be generated at the lower end of the conduction band was simulated based on these two physical property values thus obtained. As a result, as shown in Fig. 4, it was found that when the starting AlN molar fraction of the AlGaN layer stacked on the n-AlInN layer 12 was 0.27, the potential barrier generated at the lower end of the conduction band between the n-AlInN layer 12 and the AlGaN layer had a minimum value (approximately 0.18 eV). Further, it was found that the potential barrier rose when the starting AlN molar fraction is smaller than 0.27 and rose when the starting AlN molar fraction is larger than 0.27. That is, Fig. 4 suggests that the resistance as an element can be minimized by setting the molar fraction of AlN at the start of crystal growth to 0.27 in the n-AlGaN composition gradient layer 14, and the resistance as an element can be increased regardless of whether the molar fraction of AlN is larger or smaller than 0.27. Then, it can be seen from Fig. 4 that when the starting AlN molar fraction is 0.36 or more, the potential barrier monotonically increases, and the resistance as an element increases accordingly.

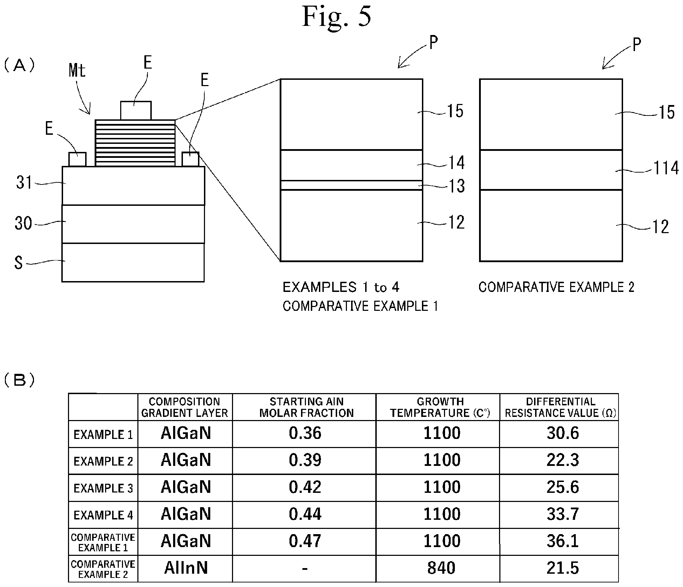

To grasp the relationship between the starting AlN molar fraction and the resistance of the n-AlInN/GaN multilayer film reflecting mirror M, five types of samples of Examples 1 to 4 and Comparative Example 1 having a multilayer film reflecting mirror Mt formed by repeating the pair P 10 times were prepared as illustrated in Fig. 5. In these samples, a u-GaN layer 30 and an n-GaN layer 31 are stacked in this order on a surface of a sapphire substrate S having a c-plane (0001) surface, and the multilayer film reflecting mirror Mt is stacked on a surface of the n-GaN layer 31. In one pair P in the multilayer film reflecting mirror Mt of these samples, the n-AlInN layer 12 (thickness: 45 nm), the GaN cap layer 13 (thickness: 0.6 nm), the n-AlGaN composition gradient layer 14 (thickness: 5 nm), and the first n-GaN layer 15 (thickness: 35 nm) are stacked in this order. In these samples, the respective starting AlN molar fraction values were changed to 0.36, 0.39, 0.42, 0.44, and 0.47. The starting AlN molar fraction in each sample is a value identified from an X-ray diffraction curve obtained by separately preparing a GaN/AlGaN superlattice under the same growth conditions.

As Comparative Example 2, a sample using an n-AlGaInN composition gradient layer 114 (thickness: 5 nm) containing many dislocations was also prepared in place of the GaN cap layer 13 and the n-AlGaN composition gradient layer 14. In principle, the n-AlGaInN composition gradient layer 114 has good conductivity because the interface with the upper part of the n-AlInN layer 12 and the interface with the lower part of the first n-GaN layer 15 do not become hetero interfaces. To measure the differential resistance value in the longitudinal direction of the multilayer film reflecting mirror Mt in each sample, the multilayer film reflecting mirror Mt was etched in a mesa shape, n-electrodes E were formed on a surface of the multilayer film reflecting mirror Mt and an on an etched surface around the multilayer film reflecting mirror Mt, and the current-voltage characteristics in the longitudinal direction were measured.

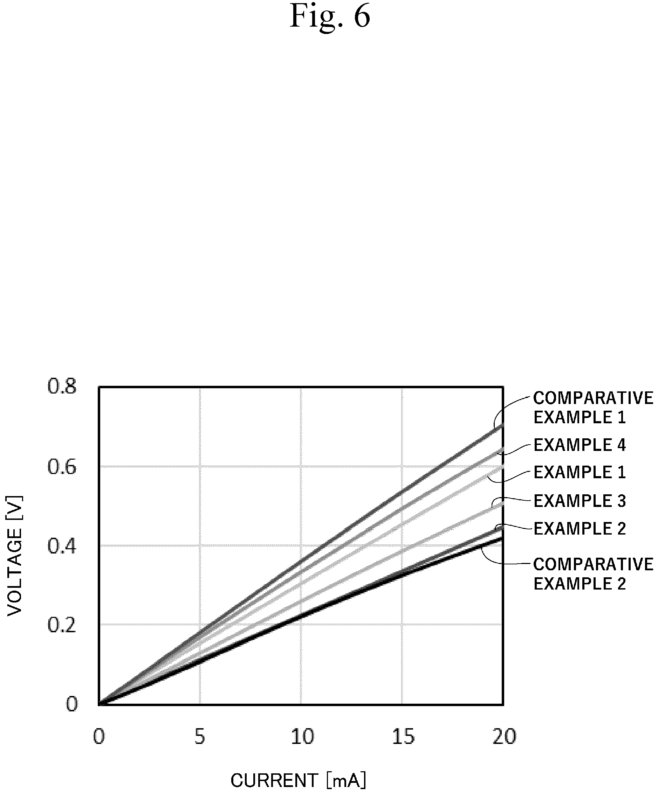

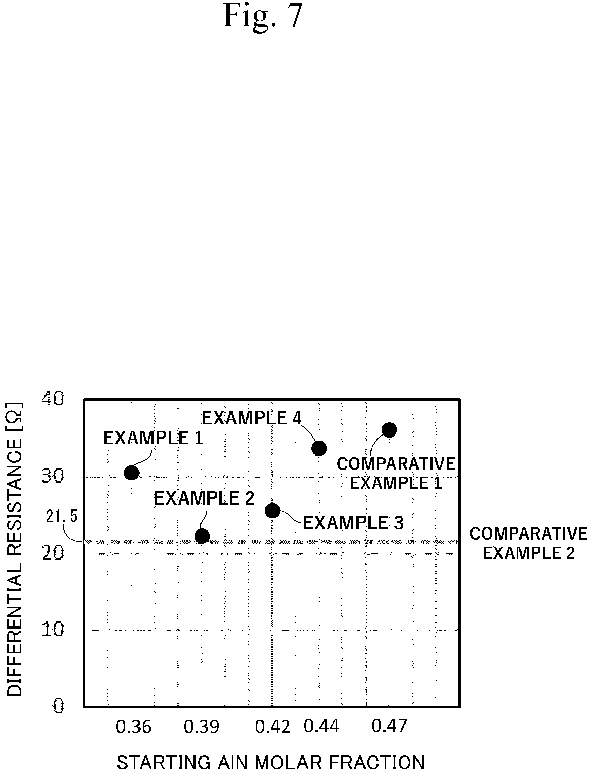

Fig. 6 shows a graph obtained by plotting the most favorable results (values having the smallest differential resistance value) in the current-voltage characteristics of each prepared sample. A graph showing the dependency of the differential resistance value on the starting AlN molar fraction to show the dependency between the starting AlN molar fraction and the differential resistance value is shown in Fig. 7. Unlike the value (0.27 is the minimum) obtained by the simulation using the theoretical value, the minimum value of the differential resistance value was obtained in the sample (sample of Example 2) having the starting AlN molar fraction of 0.39. The differential resistance value increases regardless of whether the starting AlN molar fraction is larger or smaller than 0.39. Further, the differential resistance value of the sample (sample of Example 2) having the starting AlN molar fraction of 0.39 was almost the same as the differential resistance value of the sample of Comparative Example 2 which uses the n-AlGaInN composition gradient layer 114 and in which a potential barrier due to a band offset at the interface between the n-AlInN layer 12 and the n-AlGaInN composition gradient layer 114 was not formed so that good conductivity is exhibited.

Specifically, as shown in Fig. 5, the sample of Example 1 (starting AlN molar fraction 0.36) had a differential resistance value of 30.6 Ω. The sample of Example 2 (starting AlN molar fraction 0.39) had a differential resistance value of 22.3 Ω. The sample of Example 3 (starting AlN molar fraction 0.42) had a differential resistance value of 25.6 Ω. The sample of Example 4 (starting AlN molar fraction 0.44) had a differential resistance value of 33.7 Ω. The sample of Comparative Example 1 (starting AlN molar fraction 0.47) had a differential resistance value of 36.1 Ω. The differential resistance value of Comparative Example 2 (sample using the n-AlGaInN composition gradient layer 114) was 21.5 Ω. From this, it was found that when the starting AlN molar fraction was 0.39 (Example 2), the influence of the band offset and the polarization charge offset was minimized, and a low differential resistance value substantially equivalent to that of the ideal n-AlGaInN composition gradient layer 114 was obtained. In other words, it was found that the potential barrier of the energy level at the lower end of the conduction band was minimized when the starting AlN molar fraction was 0.39 (Example 2).

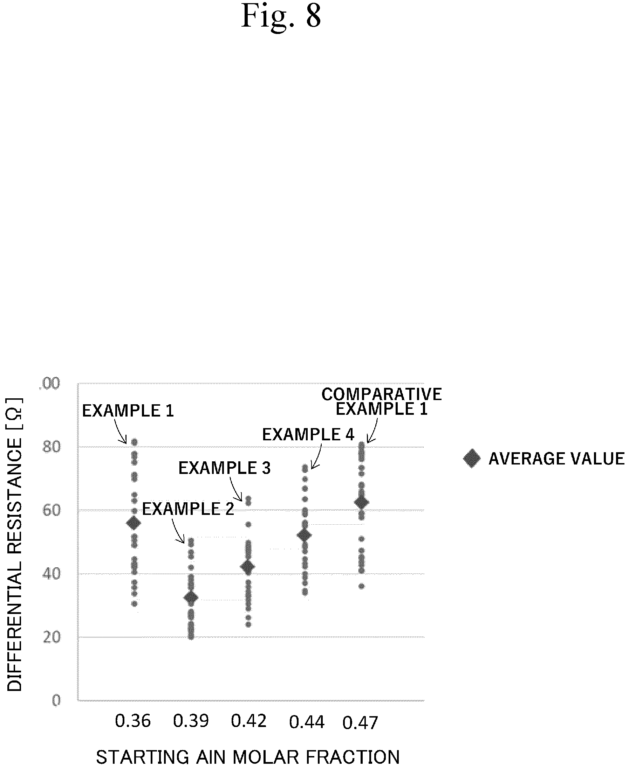

Further, Fig. 8 shows a graph in which not only the minimum value of the differential resistance value but also the results of measuring the differential resistance value 32 times while changing the measurement position in each of the five types of samples of Examples 1 to 4 and Comparative Example 1 and the average value of these measurement results are plotted. That is, the measurement results shown in Fig. 8 are results including the distribution in the wafer in each sample. The average value of the differential resistance values in each sample also showed that the minimum differential resistance value was obtained when the starting AlN molar fraction was 0.39.

The results of the simulation shown in Fig. 4 suggest that when the starting AlN molar fraction is 0.27 or more, that is, 0.36 or more, the differential resistance value monotonically increases with an increase in the starting AlN molar fraction. On the other hand, according to the examination results shown in Fig. 8, when the starting AlN molar fraction is larger than 0.36, the differential resistance value decreases, and takes a minimum value at the starting AlN molar fraction of 0.39. Further, with the starting AlN molar fraction of more than 0.39 to approximately 0.44, the differential resistance values exhibit values as low as in the case of the starting AlN molar fraction of 0.36. It was found that the differential resistance value at the starting AlN molar fraction of 0.47 or more was larger than that at the starting AlN molar fraction of 0.36.

From the above verification results, it was found that, in a range in which the starting AlN molar fraction is 0.36 or more and 0.44 or less, a low resistance region in which the differential resistance value unpredictable from the simulation results (theoretical value) is low is present, and a low-resistance n-AlInN/GaN multilayer film reflecting mirror M can be prepared by setting the starting AlN molar fraction in this range. It was also found that a lower resistance n-AlInN/GaN multilayer film reflecting mirror M can be prepared by more preferably setting the starting AlN molar fraction to 0.39 or more and 0.42 or less. That is, it has been found that there is an appropriate starting AlN molar fraction range (0.36 or more and 0.44 or less) to reduce the differential resistance value in the longitudinal direction of the n-AlInN/GaN multilayer film reflecting mirror M in which a plurality of pairs P is stacked. That is, the molar fraction of AlN at the interface of the n-AlGaN composition gradient layer 14 stacked on the surface of the GaN cap layer 13 is preferably 0.36 or more and 0.44 or less.

In this verification, a sample obtained by repeating the crystal growth of the pair P 10 times is used, but it is considered that the effect of reducing the differential resistance value in the longitudinal direction can be exhibited by setting the starting AlN molar fraction to this range (0.36 or more and 0.44 or less) even when the number of pairs P to be stacked is 11 or more. In other words, in the n-AlInN/GaN multilayer film reflecting mirror M using the n-AlGaN composition gradient layer 14, the differential resistance value in the longitudinal direction of the n-AlInN/GaN multilayer film reflecting mirror M in which a plurality of pairs P is stacked can be favorably reduced by setting the starting AlN molar fraction of the n-AlGaN composition gradient layer 14 to a value between 0.36 or more and 0.44 or less.

### [Preferable thickness of n-AlGaN composition gradient layer]

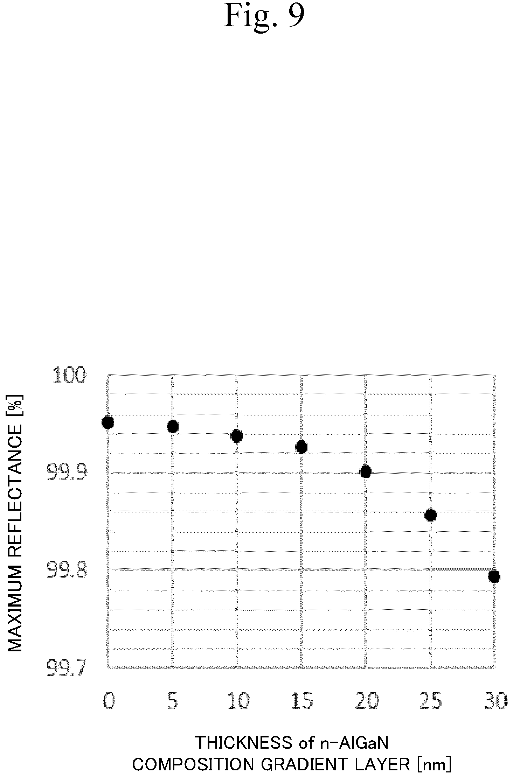

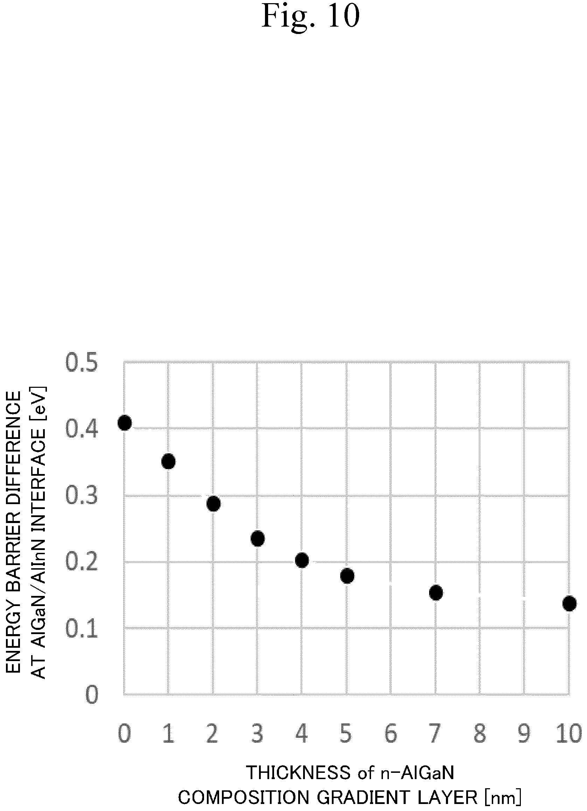

When the thickness of the n-AlGaN composition gradient layer 14 in the stacking direction is further increased, the potential barrier is decreased and low resistance is obtained, but the step difference in refractive index is substantially decreased, and thus the reflectance decreases. When the thickness of the n-AlGaN composition gradient layer 14 is further reduced, the opposite result is obtained. Here, Fig. 9 shows the calculation results of the dependency of the maximum reflectance on the thickness of the n-AlGaN composition gradient layer 14. Fig. 10 shows the calculation results of the dependency of an energy barrier generated at the interface between the n-AlInN layer 12 and the n-AlGaN composition gradient layer 14 (hereinafter, also simply referred to as energy barrier) on the thickness of the n-AlGaN composition gradient layer 14. As shown in Fig. 9, the thickness of the n-AlGaN composition gradient layer 14 is preferably 15 nm or less at which a reflectance of 99.9% or more, which is essential for a surface-emitting laser, can be realized and a decrease in reflectance is gentle.

On the other hand, as shown in Fig. 10, the degree of decrease in the energy barrier is steep when the thickness of the n-AlGaN composition gradient layer 14 is from 0 nm to 4 nm. However, when the thickness of the n-AlGaN composition gradient layer 14 is 4 nm or more, the degree of decrease in the energy barrier is moderate. Thus, to obtain the n-AlInN/GaN multilayer film reflecting mirror M in which the differential resistance value is favorably reduced, the thickness of the n-AlGaN composition gradient layer 14 is preferably set to 4 nm or more. Therefore, to obtain the n-AlInN/GaN multilayer film reflecting mirror M that achieves both a low differential resistance value and a high reflectance, the thickness of the n-AlGaN composition gradient layer 14 in the stacking direction is preferably set to 4 nm or more and 15 nm or less. It is considered that this value range is a range in which both a low differential resistance value and a high reflectance can be achieved in the n-AlInN/GaN multilayer film reflecting mirror M regardless of the magnitude of the starting AlN molar fraction value.

### <Example 5, Comparative Examples 3 and 4>

### [Verification of surface state of n-AlInN/GaN multilayer film reflecting mirror using n-AlGaN composition gradient layer]

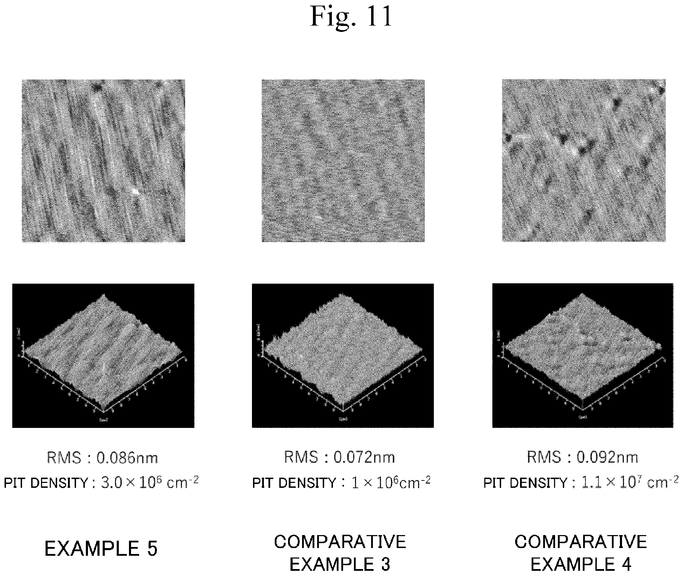

Next, a result of verifying the surface state of the n-AlInN/GaN multilayer film reflecting mirror M using the n-AlGaN composition gradient layer 14 will be described. As Example 5, a sample was prepared in which 40 pairs were formed on a GaN substrate, with the starting AlN molar fraction of the n-AlGaN composition gradient layer 14 set to 0.39 at which the lowest differential resistance value was obtained. As Comparative Example 3, a sample was prepared in which 40 pairs of non-conductive multilayer film reflecting mirrors in which the n-AlGaN composition gradient layer 14 was not provided and to which Si was not added were formed on a GaN substrate. As Comparative Example 4, a sample was prepared in which 40 pairs of conductive multilayer film reflecting mirrors each of which has an n-AlGaInN composition gradient layer and to which Si was added were formed on a GaN substrate. An AFM image obtained by measuring the surface of each of the samples of Example 5 and Comparative Examples 3 and 4 over a range of 10 µm × 10 um is shown in Fig. 11.

On the surface of the sample of Comparative Example 3, no pit was observed in the measurement range of 10 µm × 10 um, and the pit density is estimated to be less than 1 × 10⁶ cm⁻². On the other hand, pits exceeding 1 × 10⁷ cm⁻² were observed on the surface of the sample of Comparative Example 4. The pit density on the surface of the sample of Example 5 was 3 × 10⁶ cm⁻². This result is almost as low as the pit density of the sample of Comparative Example 3. This means that the n-AlInN/GaN multilayer film reflecting mirror M having good conductivity and crystallinity, that is, surface flatness, can be prepared by using the n-AlGaN composition gradient layer 14 having a starting AlN molar fraction of 0.36 or more and 0.44 or less. In other words, the n-AlInN/GaN multilayer film reflecting mirror M having good surface flatness can be prepared by setting the starting AlN molar fraction of the n-AlGaN composition gradient layer 14 to 0.36 or more and 0.44 or less.

Now, the description returns to the method for preparing the nitride semiconductor light emitting element 1 in Fig. 1. After the crystal growth of the pair P is repeated 40 times to form an n-AlInN/GaN multilayer film reflecting mirror M, the second n-GaN layer 16 having a thickness of 400 nm is crystal-grown on a surface of the n-AlInN/GaN multilayer film reflecting mirror M at a growth temperature of 1050°C. The supply amount of SiH₄ into the reaction furnace is adjusted such that the concentration of Si in the second n-GaN layer 16 becomes 5 × 10¹⁸ cm⁻³.

Next, the GaInN quantum well active layer 17 formed by stacking one pair of a GaInN quantum well layer and a GaN barrier layer five times is grown on a surface of the second n-GaN layer 16. Then, the p-AlGaN layer 18 having a thickness of 20 nm is crystal-grown on a surface of the GaInN quantum well active layer 17. The molar fraction of AlN in the p-AlGaN layer 18 is 0.2, and the molar fraction of GaN is 0.8. The supply amount of Cp₂Mg is adjusted such that the concentration of Mg in the p-AlGaN layer 18 becomes 2 × 10¹⁹ cm⁻³.

Next, the p-GaN layer 19 having a thickness of 70 nm is crystal-grown as a p-type clad layer on a surface of the p-AlGaN layer 18. The supply amount of Cp₂Mg is adjusted such that the concentration of Mg in the p-GaN layer 19 becomes 2 × 10¹⁹ cm⁻³. Then, the p-GaN contact layer 20 is crystal-grown on a surface of the p-GaN layer 19. The supply amount of Cp₂Mg is adjusted such that the concentration of Mg in the p-GaN contact layer 20 becomes 2 × 10²⁰ cm⁻³.

In this way, a resonator structure including: the n-AlInN/GaN multilayer film reflecting mirror M having the n-AlGaN composition gradient layer 14 having a starting AlN molar fraction of 0.39, in which crystal growth of the pair P has been repeated 40 times; and the GaInN quantum well active layer 17 which is sandwiched between the pn junctions and emits light in the purple region, is formed. This resonator has an integral multiple of the emission wavelength, and the resonator length corresponds to four wavelengths.

As illustrated in Fig. 1, an insulating film 21, the p-side electrode 22A, the n-side electrode 22B, and a SiO₂/Nb₂O₅ dielectric multilayer film reflecting mirror D are crystal-grown on a wafer having the n-AlInN/GaN multilayer film reflecting mirror M and the resonator structure, whereby a surface-emitting laser is completed. Hereinafter, the steps of crystal-growing the insulating film 21, the p-side electrode 22A, the n-side electrode 22B, and the SiO₂/Nb₂O₅ dielectric multilayer film reflecting mirror D preparing a surface-emitting laser (nitride semiconductor light emitting element) to prepare the surface-emitting laser (nitride semiconductor light emitting element) will be described.

First, after the p-GaN contact layer 20 is crystal-grown, H is removed from the p-type semiconductor layer (the p-AlGaN layer 18, the p-GaN layer 19, and the p-GaN contact layer 20) of the semiconductor wafer, and Mg which is a p-type dopant added to the p-type semiconductor layer is activated. Next, patterning with a photoresist is formed on a surface of the semiconductor wafer, and partial etching is performed to form a mesa structure having a circular shape with a diameter of 40 um serving as an element.

Then, a SiO₂ film having a thickness of 20 nm is stacked on a surface of the p-GaN contact layer 20, and the insulating film 21 in which a circular opening H having a diameter of 10 um is formed is formed by photolithography and sputtering. Then, the transparent p-side electrode 22A made of ITO is formed by a sputtering method so as to be in contact with the surface of the p-GaN contact layer 20 exposed from the opening H. In addition, the n-side electrode 22B is provided on the back surface of the n-GaN substrate 10. Then, a pad electrode made of Cr/Ni/Au (not illustrated) is formed on an outer peripheral portion of a surface of the p-side electrode 22A.

Finally, the SiO₂/Nb₂O₅ dielectric multilayer film reflecting mirror D is crystal-grown on a surface of the p-side electrode 22A by photolithography and sputtering. In this manner, a nitride semiconductor light emitting element that includes the SiO₂/Nb₂O₅ dielectric multilayer film reflecting mirror D above the GaInN quantum well active layer 17 and the n-AlInN/GaN multilayer film reflecting mirror M below and functions as a vertical cavity surface-emitting laser having a resonator length corresponding to an integral multiple of a wavelength is completed.

Since this element has a multilayer film reflecting mirror having favorable conductivity, crystallinity, and surface flatness, uniformity of an injection current in a plane is high, and element resistance is low, which enables high efficiency and high output operation. In addition, since there are few pits and defects, the element life is long and the reliability is high.

Next, the operation in the above examples will be described.

The nitride semiconductor light emitting element 1 includes the n-AlInN layer 12 containing Al and In in its composition, the GaN cap layer 13 stacked on a surface of the n-AlInN layer 12 and containing Ga in its composition, and the n-AlGaN composition gradient layer 14 stacked on a surface of the GaN cap layer 13 and containing Al and Ga in its composition. A molar fraction of AlN at an interface of the n-AlGaN composition gradient layer 14 stacked on a surface of the GaN cap layer 13 is 0.36 or more and 0.44 or less. With this configuration, a difference in the energy barrier generated between the n-AlInN layer 12 and the n-AlGaN composition gradient layer 14 can be reduced so that exchange of electrons between the n-AlInN layer 12 and the n-AlGaN composition gradient layer 14 can be improved.

The first n-GaN layer 15 stacked on a surface of the n-AlGaN composition gradient layer 14 and having a smaller molar fraction of AlN than that of the n-AlInN layer 12 and containing Ga in its composition is further provided, and the composition of the n-AlGaN composition gradient layer 14 is inclined such that the molar fraction of AlN in the n-AlGaN composition gradient layer 14 gradually decreases toward the interface with the first n-GaN layer 15. With this configuration, the energy barrier generated at the interface between the n-AlGaN composition gradient layer 14 and the first n-GaN layer 15 can be reduced, so that conductivity between the n-AlGaN composition gradient layer 14 and the first n-GaN layer 15 can be improved, and consequently, exchange of electrons from the n-AlInN layer 12 to the first n-GaN layer 15 can be improved (that is, conductivity can be improved).

The cap layer has the thickness in the stacking direction of larger than 0 and 1 nm or less. With this configuration, the surface of the n-AlInN layer 12 can be favorably protected.

The n-AlGaN composition gradient layer 14 has the thickness in the stacking direction of 4 nm or more and 15 nm or less. With this configuration, both a low differential resistance value and high reflection can be achieved.

A method for producing a nitride semiconductor light emitting element is a method for producing a nitride semiconductor light emitting element using metal organic vapor phase epitaxy, the method including a first layer stacking step of crystal-growing the n-AlGaN composition gradient layer 14 containing Al and In in its composition, a cap layer stacking step of crystal-growing the GaN cap layer 13 containing Ga in its composition on a surface of the n-AlGaN composition gradient layer 14 after the first layer stacking step is performed, a second layer stacking step of crystal-growing the n-AlGaN composition gradient layer 14 containing Al and Ga in its composition on a surface of the GaN cap layer 13 after the cap layer stacking step is performed, and a third layer stacking step of crystal-growing the first n-GaN layer 15 containing Ga in its composition on a surface of the n-AlGaN composition gradient layer 14 after the second layer stacking step is performed. A temperature at which the n-AlGaN composition gradient layer 14 is crystal-grown in the second layer stacking step is higher than a temperature at which the first n-GaN layer 15 is crystal-grown in the third layer stacking step. With this configuration, the migration of Al can be activated in the second layer stacking step, and thus the surface of the n-AlGaN composition gradient layer 14 can be easily flattened, which leads to an improvement in quality of the first n-GaN layer 15 which is subsequently crystal-grown.

It should be considered that the embodiment disclosed herein is an example in all respects and is not restrictive. The scope of the present invention is not limited to the embodiment disclosed herein, but is indicated by the claims, and is intended to include all modifications within the meaning and scope equivalent to the claims.
(1) Unlike the examples described above, Ge, Te, or the like may be used as the n-type impurity.
(2) Unlike the examples described above, crystal growth may be performed using another substrate such as a sapphire substrate.
(3) Unlike the examples described above, the GaN cap layer may contain an element other than GaN.
(4) The temperature at which the crystal growth is performed in the second layer stacking step and the temperature at which the crystal growth is performed in the third layer stacking step are not limited to the temperatures disclosed in the examples described above. The temperature at which the crystal growth is performed in the second layer stacking step may be the same as the temperature at which the crystal growth is performed in the third layer stacking step. That is, the temperature at which the crystal growth is performed in the second layer stacking step only needs to be equal to or higher than the temperature at which the crystal growth is performed in the third layer stacking step.
(5) Unlike the examples described above, the first n-GaN layer (third layer) may contain AlN at a molar fraction lower than that of the n-AlInN layer (first layer). That is, the third layer only needs to be a layer that is stacked on a surface of the n-AlGaN composition gradient layer (second layer), has a smaller molar fraction of AlN than that of the first layer, and contains Ga in its composition.

### REFERENCE SIGNS LIST

1 nitride semiconductor light emitting element
12 n-AlInN layer (first layer)
13 GaN cap layer (cap layer)
14 n-AlGaN composition gradient layer (second layer)
15 first n-GaN layer (third layer)

## Claims

1. A nitride semiconductor light emitting element comprising:
a first layer containing Al and In in a composition of the first layer;
a cap layer stacked on a surface of the first layer and containing Ga in a composition of the cap layer; and
a second layer stacked on a surface of the cap layer and containing Al and Ga in a composition of the second layer,
wherein a molar fraction of AlN at an interface of the second layer stacked on the surface of the cap layer is 0.36 or more and 0.44 or less.

2. The nitride semiconductor light emitting element according to claim 1, further comprising a third layer stacked on a surface of the second layer, the third layer having a molar fraction of AlN smaller than that of the first layer and containing Ga in a composition of the third layer,
wherein the composition of the second layer is inclined such that a molar fraction of AlN in the second layer gradually decreases toward an interface with the third layer.

3. The nitride semiconductor light emitting element according to claim 1 or 2, wherein the cap layer has a thickness in a staking direction of larger than 0 and 1 nm or less.

4. The nitride semiconductor light emitting element according to claim 1 or 2, wherein the second layer has a thickness in a stacking direction of 4 nm or more and 15 nm or less.

5. A method for producing a nitride semiconductor light emitting element using metal organic vapor phase epitaxy, the method comprising:
a first layer stacking step of crystal-growing a first layer containing Al and In in a composition of the first layer;
a cap layer stacking step of crystal-growing a cap layer containing Ga in a composition of the cap layer on a surface of the first layer after the first layer stacking step is performed;
a second layer stacking step of crystal-growing a second layer containing Al and Ga in a composition of the second layer on a surface of the cap layer after the cap layer stacking step is performed; and
a third layer stacking step of crystal-growing a third layer containing Ga in a composition of the third layer on a surface of the second layer after the second layer stacking step is performed,
wherein a temperature at which the second layer is crystal-grown in the second layer stacking step is equal to or higher than a temperature at which the third layer is crystal-grown in the third layer stacking step.
